# DEMANDE DE BREVET EUROPEEN

(11) **EP 0 762 580 A1**
(43) Date de publication de la demande: **12.03.1997**
(21) Numéro de dépôt: 96401806.3
(22) Date de dépôt: 22.08.1996
(51) Int. Cl.: H01S 3/25, H01S 3/025, H01S 3/085, G02B 6/16, H04B 10/17

(54) **Amplificateur optique à faible diaphone**

(30) Priorité: 24.08.1995 FR 9510057
(71) Demandeur: ALCATEL N.V., NL-2288 BH Rijswijk (NL)
(72) Inventeur: Ducellier,Thomas, 91440 Bures sur Yvette (FR); Doussiere, Pierre, 91180 Saint Germain les Arpajons (FR)
(74) Mandataire: Fournier, Michel

(57) **Abrégé**

Un substrat semiconducteur (H) comporte un guide actif (G) pour guider des signaux optiques à amplifier occupant dans le spectre des canaux de signaux intérieurs à une bande de gain de ce guide.

Un système stabilisateur est constitué de deux réflecteurs de Bragg (BA et BB) accordés sur une longueur d'onde de résonance incluse dans cette bande de gain mais extérieure aux canaux de signaux. Il inclut le segment de gain (D) dans une cavité résonance. Deux réflecteurs de Bragg réjecteurs (BC, BD) encadrant cette cavité résonance sont accordés sur cette longueur d'onde de résonance.
L'invention s'applique notamment aux systèmes de télécommunications.

## Description

La présente invention concerne les systèmes de télécommunications en optique guidée avec multiplexage en longueur d'onde. Elle vise notamment à éviter autant que possible la diaphonie entre les divers canaux spectraux occupés par les signaux à transmettre. Il est notamment nécessaire pour cela de disposer d'amplificateurs optiques à faible diaphonie. De tels amplificateurs connus sont constitués par des fibres optiques dopées à l'erbium et pompées optiquement. Ils présentent notamment l'inconvénient d'être difficilement intégrables avec d'autres composants optiques constitués de semiconducteurs.

D'autres amplificateurs optiques sont constitués de semiconducteurs. Un tel amplificateur comporte
- un guide actif formé dans un substrat semiconducteur pour guider un multiplex constitué par des signaux optiques à amplifier occupant respectivement dans le spectre des canaux de signaux, la bande de gain de ce guide incluant lesdits canaux de signaux,
- deux couches de deux types de conductivité opposés (N et P) formées dans ce substrat de part et d'autre de ce guide pour permettre à un courant électrique d'alimentation d'injecter des porteurs de charge dans ce guide,
- et des électrodes pour permettre de faire passer ledit courant électrique d'alimentation dans un segment de la longueur de ce guide, ce segment constituant un segment de gain.

Un tel amplificateur présente malheureusement une forte diaphonie jusqu'à des fréquences de modulation de plusieurs gigahertz, du moins lorsque l'amplificateur travaille au voisinage de son régime de saturation. Le gain est, en première approximation, une fonction linéaire de la densité de porteurs de charge électrique dans le guide actif. Cette densité de porteurs résulte d'un équilibre entre l'injection de porteurs par un courant électrique d'alimentation et la recombinaison de ces porteurs par émission stimulée liée à l'amplification du multiplex d'entrée. Toute modification de la puissance globale de ce multiplex modifie la densité de porteurs et donc le gain de l'amplificateur. Lorsque cette puissance augmente, le gain baisse. Inversement, lorsqu'elle diminue, le gain revient à sa valeur initiale.

Ces variations du gain sont très rapide. Ainsi, après une coupure instantanée du multiplex d'entrée, le temps de récupération du gain est de l'ordre de 200 picosecondes. Le gain varie donc en fonction des données binaires modulant les signaux amplifiés, malgré la fréquence de modulation très élevée généralement utilisée dans le domaine des télécommunications optiques. Ces fluctuations du gain engendrent ladite diaphonie entre les différents canaux.

Cette diaphonie pourrait être diminuée en faisant travailler l'amplificateur loin en dessous de son régime de saturation. Mais cela diminuerait le rapport signal à bruit, ce qui dégraderait la qualité de la transmission.

C'est pourquoi pour limiter la diaphonie, un amplificateur optique à semiconducteur connu comporte en outre un système stabilisateur constitué de deux ou d'au moins un réflecteur de Bragg couplé audit guide et présentant des lignes d'égal indice perpendiculaires à la direction de ce guide. Ce système est accordé sur une longueur d'onde de résonance incluse dans ladite bande de gain tout en étant extérieure auxdits canaux de signaux. Il inclut le segment de gain dans une cavité résonante pour y entretenir une oscillation optique à cette longueur d'onde.

Dès l'apparition de cette oscillation stabilisatrice, le gain du matériau actif se vérrouille au niveau nécessaire pour compenser les pertes de la cavité, et ne varie plus avec la puissance incidente : les variations d'amplitudes présentées par le multiplex d'entrée sont compensées par les variations d'amplitude de l'oscillation stabilisatrice.

Un tel amplificateur connu à faible diaphonie est dit "à gain stabilisé". Il est décrit dans la demande de brevet français n°93 101 47 déposée le 20 Août 1993 et publiée sous le n°2 709 189.

Malgré les avantages qu'il présente par rapport à des amplificateurs antérieurs il est apparu que le fonctionnement de systèmes de télécommunications utilisant cet amplificateur à faible diaphonie présentait parfois des imperfections.

La présente invention a notamment pour buts :
- d'améliorer le fonctionnement d'un système de télécommunications utilisant des amplificateurs à faible diaphonie,
- de limiter le coût de ces amplificateurs,
- et de faciliter la réalisation de tels systèmes en permettant de réaliser simplement des composants intégrés comportant de tels amplificateurs.

selon cette invention un amplificateur à gain stabilisé comporte en outre au moins un réflecteur réjecteur couplé au guide actif à l'extérieur de ladite cavité résonante, ce réflecteur rejecteur étant un réflecteur de Bragg accordé sur ladite longueur d'onde de résonance et présentant des lignes d'égal indice inclinées sur la direction de ce guide pour rejeter hors de ce guide une lumière parasite émise à cette longueur d'onde par cette cavité.

Il a en effet été trouvé que certaines desdites imperfections de fonctionnement des systèmes antérieurs étaient liées à l'émission d'une telle lumière parasite.

A l'aide des figures schématiques ci-jointes, on va décrire plus particulièrement ci-après, à titre d'exemple non limitatif, comment la présente invention peut être mise en oeuvre. Lorsqu'un même élément est représenté sur plusieurs figures il y est désigné par le même signe de référence.

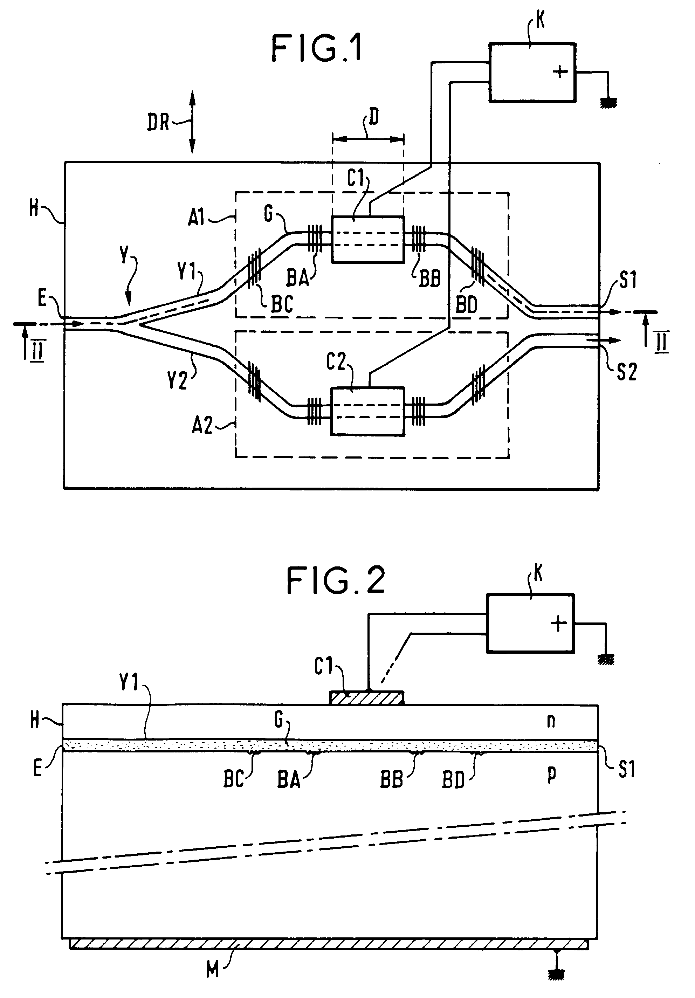

La figure 1 représente une vue de dessus d'un composant selon cette invention.

La figure 2 représente une vue du composant de la figure 1 en coupe selon une ligne II-II suivant l'axe d'un guide optique de ce composant.

Un amplificateur A1 de ce composant comporte les éléments suivants :
- Un guide G formé dans un substrat semiconducteur H pour guider un multiplex constitué par une pluralité de signaux optiques à amplifier occupant respectivement dans le spectre une pluralité de canaux de signaux. Ce guide est actif dans le segment D c'est-à-dire qu'il est apte à recombiner des porteurs de charges des deux types de conductivité opposés pour présenter un gain pour les ondes optiques situées dans une bande spectrale constituant une bande de gain. Cette bande de gain inclue lesdits canaux de signaux. Ce guide a une longueur et il présente en chacun de ses points une direction,
- Deux couches de deux types de conductivité opposés N et P formées dans ce substrat de part et d'autre de ce guide pour permettre à un courant électrique d'alimentation d'injecter lesdits porteurs de charge dans ce guide.
- Des électrodes C1 et M pour permettre de faire passer un dit courant électrique d'alimentation conférant ledit gain au guide G dans un segment de la longueur de ce guide. Ce segment constitue un segment de gain D.
- Un système stabilisateur constitué de deux réflecteurs de Bragg BA et BB couplés audit guide G et présentant des lignes d'égal indice perpendiculaires à la direction de ce guide. Ce système est accordé sur une longueur d'onde de résonance incluse dans ladite bande de gain tout en étant extérieure auxdits canaux de signaux. Il inclut ledit segment de gain dans une cavité résonante pour y entretenir une oscillation optique à cette longueur d'onde. Il pourrait aussi être constitué par un seul tel réflecteur s'étendant sur toute la longueur de la cavité résonante à former. Ladite oscillation est une oscillation stabilisatrice présentant des variations d'amplitude qui maintiennent le gain du segment de gain à une valeur constante en compensant les variations d'amplitude présentées par l'ensemble des signaux.
- Enfin au moins un réflecteur réjecteur BC du type de Bragg couplé au guide G à l'extérieur de ladite cavité résonante. Ce réflecteur est accordé sur ladite longueur d'onde de résonance. Il présente des lignes d'égal indice inclinées sur la direction du guide pour rejeter hors de ce guide une lumière parasite émise à cette longueur d'onde par cette cavité.

Avantageusement les lignes d'égal indice du système stabilisateur BA, BB et du réflecteur rejecteur BC sont parallèles à une même direction de reflecteur DR. Le guide G est alors incurvé pour présenter une direction perpendiculaire à cette direction de réflecteur dans le système stabilisateur et une direction inclinée sur cette direction de réflecteur dans le réflecteur rejecteur. Cette disposition présente l'avantage que, lors de la réalisation des reflecteurs de Bragg par un procédé connu formant les lignes d'égal indice selon des franges d'interférence formées par des faisceaux de lumière ultaviolette, la direction de ces franges reste toujours la même, ce qui évite des réglages angulaires délicats. De plus la direction de reflecteur peut être choisie d'une manière optimale par rapport au réseau monocristallin du substrat H.

Avantageusement deux réflecteurs rejecteurs BC, BD encadrent la cavité résonante BA, BB.

La présente invention a également pour objet un composant optique semiconducteur multifonctionnel. Ce composant inclut plusieurs organes formés sur un même substrat semiconducteur H pour assurer plusieurs fonctions respectives, l'un de ces organes étant un amplificateur A1 du type précédemment décrit.

Un tel composant est par exemple un commutateur comportant une entrée E et deux sorties S1 et S2. Il est alors constitué par un coupleur d'entrée Y passif dont les deux branches Y1 et Y2 alimentent respectivement deux amplificateurs A1 et A2 tels que précédemment décrit.

Une source électrique de commande K alimente soit l'electrode de commande C1 de l'amplificateur A1 soit l'electrode de commande C2 de l'amplificateur A2 pour qu'un multiplex parvenant sur l'entrée E ressorte soit sur la sortie S1 soit sur la sortie S2, respectivement.

Un composant selon l'invention peut aussi comporter, par exemple, un amplificateur tel que précédemment décrit et un récepteur faisant passer les signaux optiques sous la forme électrique.

## Revendications

1. Amplificateur optique à faible diaphonie comportant :
- un guide (G) formé dans un substrat semiconducteur (H) pour guider un multiplex constitué par une pluralité de signaux optiques à amplifier occupant respectivement dans le spectre une pluralité de canaux de signaux, ce guide étant apte à recombiner des porteurs de charges des deux types de conductivité opposés pour présenter un gain pour les ondes optiques situées dans une bande spectrale constituant une bande de gain, cette bande de gain incluant lesdits canaux de signaux, ce guide ayant une longueur et présentant en chacun de ses points une direction,
- deux couches de deux types de conductivité opposés (N et P) formées dans ce substrat de part et d'autre de ce guide pour permettre à un courant électrique d'alimentation d'injecter lesdits porteurs de charge dans ce guide,
- des électrodes (C1 et M) pour permettre de faire passer un dit courant électrique d'alimentation conférant ledit gain audit guide dans un segment de la longueur de ce guide, ce segment constituant un segment de gain (D),
- et un système stabilisateur constitué d'au moins un réflecteur de Bragg (BA et BB) couplé audit guide (G) et présentant des lignes d'égal indice perpendiculaires à la direction de ce guide, ce système étant accordé sur une longueur d'onde de résonance incluse dans ladite bande de gain tout en étant extérieure auxdits canaux de signaux, ce système incluant ledit segment de gain dans une cavité résonante pour y entretenir une oscillation optique à cette longueur d'onde,
cet amplificateur étant caractérisé par le fait qu'il comporte en outre au moins un réflecteur réjecteur (BC) couplé audit guide à l'extérieur de ladite cavité résonante, ce réflecteur rejecteur étant un réflecteur de Bragg accordé sur ladite longueur d'onde de résonance et présentant des lignes d'égal indice inclinées sur ladite direction du guide pour rejeter hors de ce guide une lumière parasite émise à cette longueur d'onde par cette cavité.

2. Amplificateur selon la revendication 1, caractérisé par le fait que lesdites lignes d'égal indice dudit système stabilisateur (BA, BB) et dudit réflecteur rejecteur (BC) sont parallèles à une même direction de reflecteur (DR), ledit guide (G) présentant une direction perpendiculaire à cette direction de réflecteur dans ce système stabilisateur et une direction inclinée sur cette direction de réflecteur dans ce réflecteur rejecteur.

3. Amplificateur selon la revendication 1 caractérisé par le fait qu'il comporte deux dits réflecteurs rejecteurs (BC, BD) encadrant ladite cavité résonante (BA, BB).

4. Composant optique semiconducteur multifonctionnel, ce composant incluant plusieurs organes formés sur un même substrat semiconducteur (H) pour assurer plusieurs fonctions respectives, l'un de ces organes étant un amplificateur (A1) selon la revendication 1.
